(19) **Europäisches Patentamt / European Patent Office / Office européen des brevets**

(11) **EP 4 365 767 B1**

(12) # EUROPEAN PATENT SPECIFICATION

(45) Date of publication and mention
of the grant of the patent:
**27.05.2026 Bulletin 2026/22**

(21) Application number: **21947513.4**

(22) Date of filing: **30.06.2021**

(51) International Patent Classification (IPC):
**B64G 1/10** *(2006.01)*  **B64G 1/24** *(2006.01)*
**B64G 3/00** *(2006.01)*

(52) Cooperative Patent Classification (CPC):
**B64G 1/242; B64G 1/1021; B64G 1/244;**
**B64G 3/00;** B64G 1/2423; Y02P 90/84

(86) International application number:
**PCT/CN2021/103428**

(87) International publication number:
**WO 2023/272559 (05.01.2023 Gazette 2023/01)**

(54) **ORBIT DESIGN SYSTEM FOR GLOBAL GREENHOUSE GAS INVENTORY SATELLITE**

ORBIT-ENTWURFSSYSTEM FÜR GLOBALEN TREIBHAUSGASINVENTARSATELLITEN

SYSTÈME DE CONCEPTION D'ORBITE POUR SATELLITE D'INVENTAIRE DE GAZ À EFFET DE
SERRE GLOBAL

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**08.05.2024 Bulletin 2024/19**

(73) Proprietors:
• **Innovation Academy for Microsatellites of CAS**
  **Shanghai 201203 (CN)**
• **Shanghai Engineering Center For Microsatellites**
  **Shanghai 201203 (CN)**

(72) Inventors:
• **TIAN, Longfei**
  **Shanghai 201203 (CN)**
• **YIN, Zengshan**
  **Shanghai 201203 (CN)**
• **LIU, Guohua**
  **Shanghai 201203 (CN)**
• **HU, Denghui**
  **Shanghai 201203 (CN)**
• **DONG, Zeying**
  **Shanghai 201203 (CN)**
• **GU, Wenjuan**
  **Shanghai 201203 (CN)**
• **GAO, Shuang**
  **Shanghai 201203 (CN)**

• **WAN, Zhiqiang**
  **Shanghai 201203 (CN)**
• **LIU, Yang**
  **Shanghai 201203 (CN)**

(74) Representative: **Qip Patent & Recht**
**Dr. Kuehn & Partner mbB**
**Bavariaring 10**
**80336 München (DE)**

(56) References cited:
EP-A1- 3 345 838        CN-A- 103 678 787
CN-A- 106 209 205       CN-A- 111 598 407
CN-A- 111 723 482       FR-A1- 2 991 299
US-A- 6 102 335         US-A- 6 102 335

• MENG BO , HAN CHAO , HUANG WEIJUN:
"Optimization of Special Elliptic Orbit
Constellation for Regional Coverage", JOURNAL
OF BEIJING UNIVERSITY OF AERONAUTICS
AND ASTRONAUTICS, vol. 34, no. 2, 15 February
2008 (2008-02-15), pages 167 - 170,
XP093020075, ISSN: 1001-5965, DOI: 10.13700/
j.bh.1001-5965.2008.02.012

**(Cont. next page)**

- **ZHENG JINGZHI , PANG HAO: "Analysis of Global Temporal and Spatial Distribution Characteristics of CO2 Based on GOSAT Satellite Data", JOURNAL OF GREEN SCIENCE AND TECHNOLOGY, no. 16, 30 August 2020 (2020-08-30), pages 88 - 89+95, XP093020083, ISSN: 1674-9944, DOI: 10.16663/ j.cnki.lskj.2020.16.029**

**Description**

**TECHNICAL FIELD**

The present invention relates to the field of carbon emission technology, and in particular to an orbit design system for global carbon inventory satellite.

**BACKGROUND**

Quantitative monitoring and assessment of carbon emissions is an important basis for realizing greenhouse gas emission reductions. Changes in atmospheric carbon dioxide concentration can reflect both anthropogenic carbon emissions and carbon absorption. Countries around the world are competing to develop space-based greenhouse gas monitoring systems to meet the major demand for global carbon inventory verification. Higher demands are now being placed on the monitoring of anthropogenic carbon emissions, and high-timeliness carbon monitoring needs to be carried out for the global human activity intensive regions.

At present, carbon monitoring satellites mainly use low-orbit sun-synchronous orbits, although such satellites can achieve global coverage, they have lower orbital positions, restricted widths, long target revisit cycles and relatively uniform global coverage, and they are unable to make encrypted observations of key human activity intensive regions, and cannot achieve the high-precision and high-timeliness monitoring of human activity intensive regions that is required for global carbon inventory. In addition, high-orbit carbon monitoring satellites use geosynchronous orbit and are positioned over a certain region, but a single satellite cannot achieve global coverage, does not have global coverage capability and can only observe within a latitude and longitude span of $\pm 50°$, with the position of the fixed point as the center.

Document US 6 102 335 A discloses an elliptical orbit satellite system which describes communication and TT&C with ground stations. Earth stations are located for the circular orbiting satellite in a way such that the line of sight can never include geo synchronous satellites. The ground stations for the elliptically orbiting satellites monitor the position of the satellite, and no antenna communicates with a satellite which is in direct line of sight between the antenna and a geo satellite. Another aspect of the invention locates two TT&C stations, separated in longitude by 90 DEG and configures these stations such that each satellite in each constellation will be able to communicate with one of the two TT&C stations once during each satellite rotation period.

**SUMMARY**

The object of the present invention is to provide an orbit design system for global carbon inventory satellite, so as to solve the problem that the orbit design of existing single carbon monitoring satellite is difficult to realize high-precision and high-timeliness monitoring of global carbon inventory.

To solve the above technical problems, the present invention provides an orbit design system for a global carbon inventory satellite as defined in claim 1, comprising:

A long residence unit in the northern hemisphere , configured to enable the global carbon inventory satellite to operate in a mid-orbit elliptical orbit, and enable the global carbon inventory satellite to be located above the latitude of the human activity intensive region when it operates to its apogee.

The orbit design system of the global carbon inventory satellite further comprises:

A frozen orbit unit, configured to set a special orbital inclination so that the global carbon inventory satellite also operates in a frozen orbit, the apogee of the frozen orbit being frozen over the latitude of the human activity intensive region;

A sun-synchronous orbit unit, configured to set synchronization parameters so that the global carbon inventory satellite also operates in a sun-synchronous orbit, so that the global carbon inventory satellite is always in the light area when it operates to the apogee; and

A regression orbit unit, configured to enable the global carbon inventory satellite to also operate in a regression orbit, obtaining observation conditions consistent with the previous regression cycle.

In the orbit design system of the global carbon inventory satellite, the latitude of the human activity intensive region is between 20°N and 45°N and, optionally;

The synchronization parameters comprise orbital inclination, orbit half-length axis and orbit eccentricity;
The observation conditions comprise satellite elevation angle and solar altitude angle of the observation point; and
The orbital parameters of the global carbon inventory satellite comprise:
The range of perigee orbital altitude is 350km~1000km, the range of apogee orbital altitude is 6800km~8300km, the range of perigee argument is 215°~235°, and the orbital period is 3h.

Optionally, in the orbit design system of the global carbon inventory satellite, the mid-orbit elliptical orbit is divided into a prograde elliptical frozen orbit and a retrograde elliptical frozen orbit according to the size of the critical inclination angle, the orbital inclination of the prograde elliptical frozen orbit is 63.4 °, and the orbital inclination of the retrograde elliptical frozen orbit is 116.565 °; and
According to the requirement that the ascending node of the sun-synchronous orbit moves eastward about 0.9856 ° every day, the orbital inclination of the global carbon inventory satellite is selected as 116.565°.

In the orbit design system of the global carbon inventory satellite, the relationship between the perigee orbital altitude and the apogee orbital altitude is obtained according to the value of the ascending node of the sun-synchronous orbit, the value of the orbital inclination, the first function and the second function;

The first function represents the relationship between the semi-major axis of the orbit on one hand and the perigee orbital altitude and the apogee orbital altitude on the other hand; and

The second function represents the relationship between the orbital eccentricity on one hand and the perigee orbital altitude and the apogee orbital altitude on the other hand.

Optionally, in the orbit design system of the global carbon inventory satellite, the precession angular rate of the orbital plane is

$$\dot{\Omega} = -9.964 \times \left(\frac{R_e}{a}\right)^{3.5} \times (1 - e^2)^{-2} \times cos i (°/day)$$

Wherein, $R_e$ is the radius of the Earth, $a$ is the semi-major axis of the orbit, e is the orbital eccentricity, and i is the orbital inclination;
The value of the ascending node of the sun-synchronous orbit satisfies the following conditions:

$$\dot{\Omega} = -9.964 \times \left(\frac{R_e}{a}\right)^{3.5} \times (1 - e^2)^{-2} \times cos i = 0.985612288 (°/day)$$

Wherein, the orbital inclination is 116.565°;
The first function is $a = (h_p + h_a)/2 + R_E$ ;

The second function is $e = 1 - \dfrac{h_p + R_E}{(h_p + h_a)/2 + R_E}$ ;

Wherein, $h_p$ is the perigee orbit altitude, $h_a$ is the apogee orbit altitude, and $R_E$ is the radius of the Earth;
The orbital inclination, the first function and the second function are substituted to obtain the combination equations of the perigee orbital altitude $h_p$ and the apogee orbital altitude $h_a$ ; and
The orbital altitude relationship curve is obtained according to the combination equations.

Optionally, in the orbit design system of the global carbon inventory satellite, after the regression orbit passing through a regression cycle, the sub-satellite point trajectory overlaps with the sub-satellite point trajectory of the previous regression cycle:

$$D^* \times 2\pi = N \times \Delta\lambda$$

Wherein, N is the number of orbits of the satellite orbiting the Earth in a regression period, D* is the number of ascending days in the regression period, and $\Delta\lambda$ is the traverse angle;

The perigee orbit altitude and the apogee orbit altitude are synchronously adjusted, while ensuring the constraint of the sun-synchronous orbit, and design of the orbit period, orbit precession, and the Earth's rotation speed is matched to obtain the regression orbit; and
The points on the orbital altitude relationship curve are selected based on the Q value, and the parameters of the regression orbit are calculated iteratively in the range of the mid-orbit elliptical orbit with the perigee orbit altitude of 350km~1000km, the apogee orbit altitude of 6800km~8300km, and orbital inclination of 116.565°.

Optionally, in the orbit design system of the global carbon inventory satellite, the apogee of the global carbon inventory satellite is set over a specific latitude in the northern hemisphere by adjusting the argument of the perigee, so that the transit time of the global carbon inventory satellite in the northern hemisphere in the region of more intensive human activities is longer, in order to observe the northern hemisphere for a longer period of time; and

According to the proportional relationship between the argument of perigee and the latitude of apogee, the argument of perigee is determined, 35 degrees of north latitude is selected as the position of apogee, and 220 degrees is selected as the perigee argument of the global carbon inventory satellite.

Optionally, in the orbit design system of the global carbon inventory satellite, the working arc segment of the global carbon inventory satellite load is at the apogee of the northern hemisphere according to the working characteristics of the global carbon inventory satellite, so that the satellite flight direction in the light area is an ascending orbit, so as to realize:

The satellite has no sunlight in the shadow area of the Earth and consumes battery power. After entering the light area, the satellite is located in the southern hemisphere, carrying out observation missions while the solar panels are recharged in preparation for long-duration observations in the northern hemisphere; and

After the satellite enters the light area, the external heat flow reaches temperature equilibrium, and the satellite reaches a stable thermal equilibrium state prior to centralized observation in the northern hemisphere in order to enhance the data quality of the infrared channel.

Optionally, in the orbit design system of the global carbon inventory satellite:

When the satellite is at different latitudes, the local time of the sub-satellite point changes, and the corresponding solar elevation changes accordingly;

When the local time of the descending node is 0 o'clock, the local time curves of the sub-satellite point of different latitudes are drawn, wherein the horizontal axis is latitude, the southern latitude is negative, the northern latitude is positive, from left to right is an orbit-raising process, and the vertical axis is the local time of the sub-satellite point;

When the satellite is at southern latitude, the local time is afternoon; when the satellite crosses the equator, the local time is 12 noon; when observing in the northern hemisphere, the local time is morning, wherein a typical orbit near the apogee of 35° N. latitude has a local time of about 10:45 am; and

According to the actual need to translate the right ascension of the ascending node, the local time will be shifted accordingly, and the adjustment method is as follows: for every 15° increase in the right ascension of the ascending node, the local time of the corresponding sub-satellite point will be increased by one hour.

In the orbit design system of the global carbon inventory satellite provided by the present invention, the global carbon inventory satellite operates in a mid-orbit elliptical orbit, and when the global carbon inventory satellite operates to its apogee, it is located above the latitude of the human activity intensive region. Due to the altitude of apogee is higher and the flight speed in the vicinity of the apogee is slower, global carbon inventory satellite can achieve long-term resident observation of the region of intensive human activities in the northern latitude (including Asia, North America, and Europe).

The apogee of the global carbon inventory satellite in the present invention is frozen over the latitude of the region of intensive human activities, which can ensure the maximization of the observation time for the northern hemisphere; it is always in the light area at the apogee, thus ensuring the relatively consistent light conditions for the observation, which is conducive to the realization of high-precision inversion of the carbon dioxide column concentration.

The present invention synchronously adjusts the altitude of the perigee and apogee of the orbit through coupling design, while ensuring the sun-synchronous characteristics of the orbit, matching design of the orbit period, orbit precession, and the rotation speed of the Earth, etc., to find the regression orbit. The regression characteristics of the orbit can ensure the periodic repeatability of the ground trajectory, thus obtaining consistent observation conditions, such as the satellite elevation angle and solar altitude angle of the observation point, which is conducive to the simplification of the design of the satellite working mode.

The global carbon inventory satellite in the present invention operates in a mid-orbit elliptical frozen sun-synchronous regression orbit, which can achieve global coverage, a higher orbital position, a larger width, and a short target revisit cycle; and it is capable of realizing high-time-frequency scanning encrypted observation for key human activity intensive regions during transit.

## BRIEF DESCRIPTION OF THE DRAWINGS

FIG.1 is a schematic diagram of the operational orbit of a global carbon inventory satellite according to an embodiment of the present invention;

FIG.2 is a schematic diagram illustrating the corresponding relationship between the perigee and apogee of the elliptical frozen sun-synchronous orbit of the global carbon inventory satellite according to an embodiment of the present invention;

FIG.3 is a schematic diagram of the sub-satellite point trajectory of the elliptical frozen sun-synchronous regression orbit of the global carbon inventory satellite according to an embodiment of the present invention;

FIG.4 is a schematic diagram illustrating the corresponding relationship between the argument of perigee and the latitude of apogee of the global carbon inventory satellite according to an embodiment of the present invention; and

FIG.5 is a schematic diagram of the local time difference of the sub-satellite points at different latitudes of the global carbon inventory satellite according to an embodiment of the present invention.

## DETAILED DESCRIPTION OF EMBODIMENTS

In the present invention, the embodiments are merely intended to illustrate the scheme of the present invention and should not be construed as limiting.

It should also be noted that, within the scope of the present invention, the terms "the same ", "equal ", "equal to", etc. do not mean that the two numerical values are absolutely equal, but rather allow for a certain reasonable error, that is to say, the terms also cover "substantially the same ", "substantially equal " and "substantially equal to".

In addition, the numbering of the steps of various methods of the present invention does not limit the order in which the steps of the method are performed. Unless otherwise indicated, the steps of various methods may be performed in a different order.

The orbital design system for the global carbon inventory satellite proposed in the present invention is described in further detail below in conjunction with the accompanying drawings and specific embodiments. The advantages and features of the present invention will become clearer according to the following description and claims. It should be noted that the accompanying drawings are in a very simplified form and use non-precise proportions, used only for convenience and clarity assisting in the illustration of the purpose of embodiments of the present invention.

The object of the present invention is to provide an orbit design system for a global carbon inventory satellite, so as to solve the problem that the orbit design of existing single carbon monitoring satellite is unable to realize high-precision and high-timeliness monitoring of global carbon inventory.

In order to achieve the above objects, the present invention provides an orbit design system for a global carbon inventory satellite, comprising: a long residence unit in the northern hemisphere , configured to enable the global carbon inventory satellite operates in a mid-orbit elliptical orbit, and enable the global carbon inventory satellite to be located above the latitude of the human activity intensive region when it operates to its apogee; a frozen orbit unit, configured to set a special orbital inclination so that the global carbon inventory satellite also operates in a frozen orbit, the apogee of the frozen orbit being frozen over the latitude of the human activity intensive region; a sun-synchronous orbit unit, configured to set synchronization parameters so that the global carbon inventory satellite also operates in a sun-synchronous orbit, so that the global carbon inventory satellite is always in the light area when it operates to the apogee.

Embodiments of the present invention provide an orbit design system for a global carbon inventory satellite, comprising: a long residence unit in the northern hemisphere, configured to enable the global carbon inventory satellite to operate in a mid-orbit elliptical orbit, and when the global carbon inventory satellite operates to its apogee, it is located above the latitude of the human activity intensive region. Ordinary low-orbit sun-synchronous orbits generally adopt circular orbits with an orbital altitude of 500km to 1,000km, and their flight speeds are 7.3km/s to 7.6km/s, corresponding to ground speeds at the sub-satellite point are 6.4km/s to 7.1km/s. Due to the low flight altitude and high speed, the transit times to specific regions on the ground are shorter, and it is impossible to carry out large-scope scanning and monitoring. However, the global carbon inventory satellite in this embodiment operates in a mid-orbit elliptical orbit, its apogee altitude is higher and speed flight in the vicinity of the apogee is slower. By setting the apogee over a specific latitude (e.g., 30°N latitude), it is able to achieve long-term resident observation of the region of intensive human activities in the northern latitude (including Asia, North America, and Europe).

In one embodiment of the present invention, in the orbit design system of the global carbon inventory satellite, further comprising: a frozen orbit unit, configured to set a special orbital inclination so that the global carbon inventory satellite also operates in a frozen orbit, the apogee of the frozen orbit being frozen over the latitude of the human activity intensive region; the argument of the perigee of a general elliptical orbit changes over time, i.e., precession occurs, leading to the latitudes of the perigee and the apogee are constantly changed, which cannot ensure long-term resident observation of the northern hemisphere region where the land and the population are more concentrated. The carbon inventory orbit proposed in the present invention adopts a special inclination angle design, which freezes the apogee over the northern hemisphere and ensures the maximization of the observation time in the northern hemisphere.

In one embodiment of the present invention, in the orbit design system of the global carbon inventory satellite, further comprising: a sun-synchronous orbit unit, configured to set synchronization parameters so that the global carbon inventory satellite also operates in a sun-synchronous orbit, so that the global carbon inventory satellite is always in the light area when it operates to the apogee; through the joint design of orbital inclination, orbital semi-major axis and eccentricity, the precession rate of the right ascension of the ascending node (RAAN) of the orbital plane is about 0.98 ° eastward per day, so as to realize the synchronous "tracking" of the sun. The orbit can ensure that the apogee is always in the light area, and the local time of the transit area in different orbits remains consistent (It is noted that there will be small changes in the local time of the sub-satellite point in one orbit), thus ensuring that the light conditions for observation are relatively consistent, which is conducive to the realization of high-precision carbon dioxide column concentration inversion.

In one embodiment of the present invention, in the orbit design system of the global carbon inventory satellite, further comprising: a regression orbit unit, configured to enable the global carbon inventory satellite to also operate in a regression orbit, obtaining observation conditions consistent with the previous regression cycle. Through the coupling design, the altitude of the perigee and apogee of the orbit are adjusted synchronously, while ensuring the sun-synchronous characteristics of the orbit, matching design of the orbit period, orbit precession, and the rotation speed of the Earth, etc., to find the regression orbit. The regression characteristics of the orbit can ensure the periodic repeatability of the ground trajectory, thus obtaining consistent observation conditions, such as the satellite elevation angle and solar altitude angle of the observation point, which is conducive to the simplification of the design of the satellite working mode.

In one embodiment of the present invention, in the orbit design system of the global carbon inventory satellite, the latitude of the human activity intensive region is between 20°N and 45°N;the synchronization parameters comprise orbital inclination, orbit half-length axis and orbit eccentricity; the observation conditions comprise satellite elevation angle and solar altitude angle of the observation point; the orbital parameters of the global carbon inventory satellite comprise: the range of perigee orbital altitude is 350km~1000km, the range of apogee orbital altitude is 6800km~8300km, the range of perigee argument is 215°~235°, and the orbital period is 3h.

In one embodiment of the present invention, in the orbit design system of the global carbon inventory satellite, the inclination angle of the elliptical frozen orbit is selected as follows: affected by the flatness of the Earth, the arch point of the elliptical orbit will precess over time, and when the known orbit inclination meets specific conditions, the precession rate of the arch point can be made to be 0, that is, the orbit arch point is realized to be "frozen", such an orbit is called a frozen orbit, and the corresponding inclination angle is the critical inclination angle. The mid-orbit elliptical orbit is divided into a prograde elliptical frozen orbit and a retrograde elliptical frozen orbit according to the size of the critical inclination angle, the orbital inclination of the prograde elliptical frozen orbit is 63.4 °, and the orbital inclination of the retrograde elliptical frozen orbit is 116.565 °; considering the precession of the ascending node, the ascending node of the prograde orbit precesses westward by a certain angle every day, and the ascending node of the retrograde orbit precesses eastward by a certain angle every day, while the sun synchronization requires that the ascending node moves eastward by about 0.9856° per day, therefore, according to the requirements of the ascending node of the sun synchronous orbit, the orbital inclination of the global carbon inventory satellite is determined to be 116.565 °.

In one embodiment of the present invention, in the orbit design system of the global carbon inventory satellite, the relationship between the perigee orbital altitude and the apogee orbital altitude is obtained according to the value of the ascending node of the sun-synchronous orbit, the value of the orbital inclination, the first function and the second function; the first function represents the relationship between the semi-major axis of the orbit on one hand and the perigee orbital altitude and the apogee orbital altitude on the other hand; the second function represents the relationship between the orbital eccentricity on one hand and the perigee orbital altitude and the apogee orbital altitude on the other hand.

In one embodiment of the present invention, in the orbit design system of the global carbon inventory satellite, the frozen characteristics of the elliptical orbit constrain the orbital inclination, and a joint design of the orbital semi-major axis and the orbital eccentricity is required under a specific orbital inclination condition. Due to the influence of the Earth's non-spherical gravitational perturbation, the orbital plane of the satellite continuously precesses in the inertial space. Only considering the long-term perturbation with harmonic term $J_2$, the precession angular rate of the orbital plane is

$$\dot{\Omega} = -9.964 \times \left(\frac{R_e}{a}\right)^{3.5} \times (1 - e^2)^{-2} \times cosi \, (°/day)$$

Wherein, $R_e$ is the radius of the Earth, $a$ is the semi-major axis of the orbit, $e$ is the orbital eccentricity, and $i$ is the orbital inclination;

The value of the ascending node of the sun-synchronous orbit satisfies the following conditions:

$$\dot{\Omega} = -9.964 \times \left(\frac{R_e}{a}\right)^{3.5} \times (1 - e^2)^{-2} \times cosi = 0.985612288 \, (°/day)$$

Wherein, the orbital inclination is 116.565°;

The first function is $a = (h_p + h_a)/2 + R_E$;

The second function is $e = 1 - \dfrac{h_p + R_E}{(h_p + h_a)/2 + R_E}$;

Wherein, $h_p$ is the perigee orbit altitude, $h_a$ is the apogee orbit altitude, and $R_E$ is the radius of the Earth;

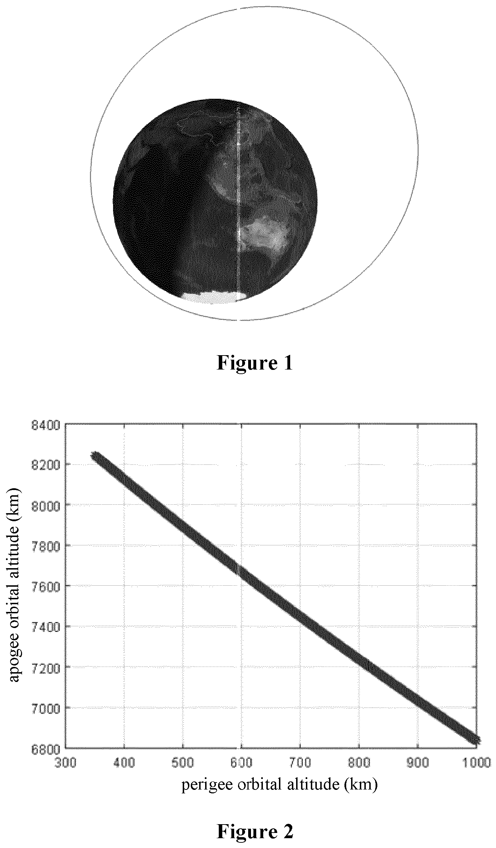

The orbital inclination, the first function and the second function are substituted to obtain the combination equations of the perigee orbital altitude $h_p$ and the apogee orbital altitude $h_a$; the orbital altitude relationship curve is obtained according to the combination equations, as shown in FIG.2. By traversing the altitude range of perigee $h_p$ from 350km to 1000km, the corresponding apogee orbital altitude can be obtained respectively, and the relationship between them is shown in FIG.2. This is the design basis of the elliptical frozen sun-synchronous orbit , which shows that the higher the perigee altitude is, the lower the apogee altitude is.

The regression orbit design is more common in earth remote sensing satellites. The sub-satellite point trajectory of this orbit periodically overlaps, which can ensure the consistent elevation angle of the satellite during the transit period, and with the sun-synchronous characteristics of the orbit, it can achieve a more consistent observation light angle, which can simplify the design of the satellite operating mode. In one embodiment of the present invention, in the orbit design system of the global carbon inventory satellite, the sub-satellite point trajectory is a synthesis of the three motions of satellite flight, orbital plane precession and the Earth's rotation, and for the regression orbit, the regression orbit after passing through a regression cycle, the sub-satellite point trajectory overlaps with the sub-satellite point trajectory of the previous regression cycle:

$$D^* \times 2\pi = N \times \Delta\lambda$$

Wherein, $N$ is the number of orbits of the satellite orbiting the Earth in a regression period, $D^*$ is the number of ascending days in the regression period, and $\Delta\lambda$ is the longitude interval of successive adjacent trajectories on the equator, i.e. the traverse angle; The perigee orbit altitude and the apogee orbit altitude are synchronously adjusted, while ensuring the constraint of the sun-synchronous orbit, matching design of the orbit period, orbit precession, and the Earth's rotation speed to obtain the regression orbit;

The points on the orbital altitude relationship curve are selected based on the Q value, and the parameters of the regression orbit are calculated iteratively in the range of the mid-orbit elliptical orbit with the perigee orbit altitude of 350km~1000km, the apogee orbit altitude of 6800km~8300km, and orbital inclination of 116.565°. After analysis, there are a total of 14 groups of orbits satisfying the characteristics of elliptical+frozen+sun-synchronous+regression in this range, as shown in Table 1.

Table 1 Design of Elliptical Frozen Sun-synchronous Regression Orbit

| Serial numbe r | Perigee altitude (km) | Apogee altitude (km) | Regression period (days) |
|---|---|---|---|
| 1. | 356.1 | 8228.99 | 8 |
| 2. | 373.9 | 8186.22 | 9 |
| 3. | 388.35 | 8151.7 | 10 |
| 4. | 522.2 | 7840.02 | 1 |
| 5. | 681.4 | 7487.47 | 9 |
| 6. | 664.9 | 7523.14 | 10 |
| 7. | 899.5 | 7033.96 | 4 |
| 8. | 818.15 | 7199.32 | 5 |
| 9. | 765.74 | 7308.22 | 6 |
| 10. | 729.11 | 7386.45 | 7 |
| 11. | 959.8 | 6914.17 | 7 |
| 12. | 702.1 | 7443.01 | 8 |
| 13. | 853.91 | 7126.09 | 9 |
| 14. | 984.51 | 6865.76 | 10 |

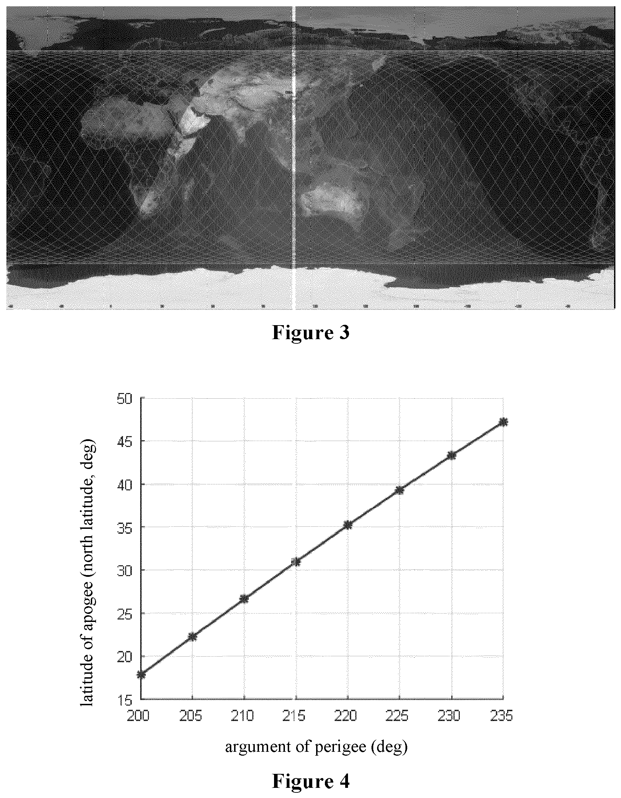

The 8th group of orbits in the table are selected as a typical carbon inventory orbit, with a regression period of 5 days, and the trajectory of the sub-satellite point over 5 days is shown in FIG.3.

In one embodiment of the present invention, in the orbit design system of the global carbon inventory satellite, the adjustment of the argument of perigee does not affect the orbital period and the orbital plane precession rate, and thus does not affect the sun-synchronization characteristics and regression characteristics of the orbit. The apogee of the global carbon inventory satellite is set over a specific latitude in the northern hemisphere by adjusting the argument of the perigee, so that the transit time of the global carbon inventory satellite in the northern hemisphere in the region of more intensive human activities is longer, in order to observe the northern hemisphere for a longer period of time; taking the 5-day regression elliptical frozen sun-synchronous orbit with a perigee altitude of 818.15km and an apogee altitude of 7,199.32km as an example, the apogee latitudes corresponding to different perigee arguments are shown in FIG.4. It can be seen from Figure 4 that the larger the argument of perigee is, the higher the corresponding apogee latitude is. Comprehensively considering the latitudinal distribution of key countries such as China, the United States, Europe, Japan and India, selecting 35 ° N as the apogee position can achieve long-term resident observation of these key countries. Therefore, the perigee argument of the global carbon inventory satellite is selected to be 220°.

In one embodiment of the present invention, in the orbit design system of the global carbon inventory satellite, the working arc segment of the global carbon inventory satellite load is at the apogee of the northern hemisphere according to the working characteristics of the global carbon inventory satellite, so that the satellite flight direction in the light area is an ascending orbit (flying from south to north), so as to realize:

The satellite has no sunlight in the shadow area of the earth and consumes battery power. After entering the light area, the satellite is located in the southern hemisphere, with fewer observation missions, carrying out observation missions while the solar panels are recharged in preparation for long-duration observations in the northern hemisphere;

After the satellite enters the light area, the external heat flow changes, and it takes a period of time to reach temperature equilibrium. The ascending orbit in the light area can ensure that the satellite reaches a stable thermal equilibrium state prior to centralized observation in the northern hemisphere in order to enhance the data quality of the infrared channel.

Optionally, in the orbit design system of the global carbon inventory satellite:

When the satellite is at different latitudes, the local time of the sub-satellite point changes, and the corresponding solar elevation changes accordingly;

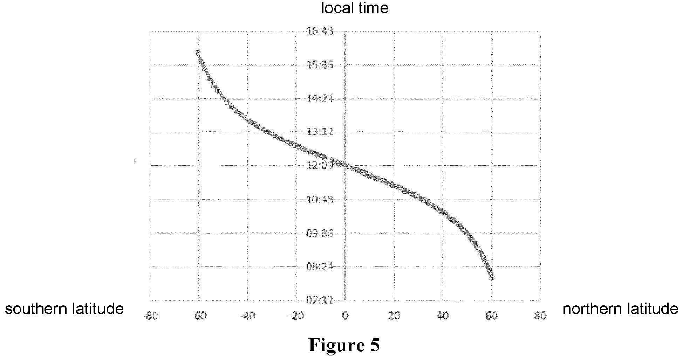

When the local time of the descending node is 0 o'clock, the local time curves of the sub-satellite point of different latitudes are drawn, as shown in FIG.5 , wherein the horizontal axis is latitude, the southern latitude is negative, the northern latitude is positive, from left to right is an orbit-raising process, and the vertical axis is the local time (24h system) of the sub-satellite point;

When the satellite is at southern latitude, the local time is afternoon; when the satellite crosses the equator, the local time is 12 noon; when observing in the northern hemisphere, the local time is morning, wherein a typical orbit near the apogee of 35° N. latitude having a local time of about 10:45 am;

According to the actual need to translate the right ascension of the ascending node, the local time will be shifted accordingly, and the adjustment method is as follows: for every 15 ° increase in the right ascension of the ascending node, the local time of the corresponding sub-satellite point will be increased by one hour.

After the above design steps, a set of satellite orbit design results suitable for global carbon inventory are obtained, and the orbit parameters and orbit characteristics are shown in Table 2.

Table 2 Satellite Orbit Design suitable for Carbon Inventory

| Serial number | Track Parameters & Characteristics | Value |
|---|---|---|
| 1. | Perigee altitude (km) | 818.15 |
| 2. | Apogee altitude (km) | 7199.32 |
| 3. | Eccentricity | 0.307175 |
| 4. | Orbital inclination (°) | 116.565 |
| 5. | Argument of perigee (°) | 220 |
| 6. | Local time at the descending node | 00:00 am |
| 7. | Latitude of apogee | 35 ° N |

(continued)

| Serial number | Track Parameters & Characteristics | Value |
|---|---|---|
| 8. | Apogee sub-satellite point local time | 10:45 am |
| 9. | Orbital period (H) | 2.92641 |
| 10. | Regression period (days) | 5 |

The revisit and coverage capability of the orbit are analyzed and compared it with low-orbit sun-synchronous orbit satellites and geosynchronous orbit satellites, the present invention provides an orbital design system for the global carbon inventory satellite, in which the global carbon inventory satellite operates in a mid-orbit elliptical orbit, and when the global carbon inventory satellite operates to its apogee, it is located above the latitude of the human activity intensive region. Due to the altitude of apogee is higher and the flight speed in the vicinity of the apogee is slower, global carbon inventory satellite can achieve long-term resident observation of the region of intensive human activities in the northern latitude (including Asia, North America, and Europe).

The apogee of the global carbon inventory satellite in the present invention is frozen over the latitude of the region of intensive human activities, which can ensure the maximization of the observation time for the northern hemisphere; it is always in the light area at the apogee, thus ensuring the relatively consistent light conditions for the observation, which is conducive to the realization of high-precision inversion of the carbon dioxide column concentration.

The present invention synchronously adjusts the altitude of the perigee and apogee of the orbit through coupling design, while ensuring the sun-synchronous characteristics of the orbit, matching design of the orbit period, orbit precession, and the rotation speed of the Earth, etc., to find the regression orbit. The regression characteristics of the orbit can ensure the periodic repeatability of the ground trajectory, thus obtaining consistent observation conditions, such as the satellite elevation angle and solar altitude angle of the observation point, which is conducive to the simplification of the design of the satellite working mode.

The global carbon inventory satellite in the present invention operates in a mid-orbit elliptical frozen sun-synchronous regression orbit, which can achieve global coverage, a higher orbital position, a larger width, and a short target revisit cycle; and it is capable of realizing high-time-frequency scanning encrypted observation for key human activity intensive regions during transit.

Although some embodiments of the present invention have been described in this application document, those skilled in the art can understand that these embodiments are only shown as examples.

**Claims**

1. An orbit design system for global carbon inventory satellite, comprising:

   a long residence unit in the northern hemisphere, configured to enable the global carbon inventory satellite to operate in a mid-orbit elliptical orbit, and enable the global carbon inventory satellite to be located above the latitude of the human activity intensive region when it operates to its apogee, wherein the latitude of the human activity intensive region is between 20°N and 45°N,
   a frozen orbit unit, configured to set a special orbital inclination so that the global carbon inventory satellite also operates in a frozen orbit, the apogee of the frozen orbit being frozen over the latitude of the human activity intensive region;
   a sun-synchronous orbit unit, configured to set synchronization parameters so that the global carbon inventory satellite also operates in a sun-synchronous orbit, so that the global carbon inventory satellite is always in the light area when it operates to the apogee; and
   a regression orbit unit, configured to enable the global carbon inventory satellite to also operate in a regression orbit, obtaining observation conditions consistent with the previous regression cycle,
   wherein the relationship between the perigee orbital altitude and the apogee orbital altitude is obtained according to the value of the ascending node of the sun-synchronous orbit, the value of the orbital inclination, the first function and the second function;
   wherein the first function represents the relationship between the semi-major axis of the orbit on one hand and the perigee orbital altitude and the apogee orbital altitude on the other hand; and
   wherein the second function represents the relationship between the orbital eccentricity on one hand and the perigee orbital altitude and the apogee orbital altitude on the other hand.

2. The orbit design system for a global carbon inventory satellite according to claim 1, wherein:

the synchronization parameters comprise orbital inclination, orbit half-length axis and orbit eccentricity;
the observation conditions comprise satellite elevation angle and solar altitude angle of the observation point; and
the orbital parameters of the global carbon inventory satellite comprise:
the range of perigee orbital altitude is 350km~1000km, the range of apogee orbital altitude is 6800km~8300km, the range of perigee argument is 215°~235°.

3. The orbit design system for a global carbon inventory satellite according to claim 2, wherein:

the mid-orbit elliptical orbit is divided into a prograde elliptical frozen orbit and a retrograde elliptical frozen orbit according to the size of the critical inclination, the orbital inclination of the prograde elliptical frozen orbit is 63.4 °, and the orbital inclination of the retrograde elliptical frozen orbit is 116.565 °; and
according to the requirement that the ascending node of the sun-synchronous orbit moves eastward about 0.9856 ° every day, the orbital inclination of the global carbon inventory satellite is selected as 116.565°.

4. The orbit design system for a global carbon inventory satellite according to claim 1, wherein:

the precession angular rate of the orbital plane is

$$\dot{\Omega} = -9.964 \times R_e\, a\, 3.5 \times 1 - e\, 2 - 2 \times \cos i \,°\,/\,day$$

wherein, Re is the radius of the Earth, a is the semi-major axis of the orbit, e is the orbital eccentricity, and i is the orbital inclination;
the value of the ascending node of the sun-synchronous orbit satisfies the following conditions:

$$\dot{\Omega} = -9.964 \times R_e\, a\, 3.5 \times 1 - e\, 2 - 2 \times \cos i = 0.985612288 \,°\,/\,day$$

wherein, the orbital inclination is 116.565°;
the first function is a = (hp + ha)/2 + RE ;
the second function is

$$e = 1 - h_p + R_E\, h_p + h_a\, / 2 + R_E;$$

wherein, hp is the perigee orbit altitude, ha is the apogee orbit altitude, and RE is the radius of the Earth;
the orbital inclination, the first function and the second function are substituted to obtain the combination equations of the perigee orbital altitude hp and the apogee orbital altitude ha; and
the orbital altitude relationship curve is obtained according to the combination equations.

5. The orbit design system for a global carbon inventory satellite according to claim 4, wherein:

the regression orbit after passing through a regression cycle, the sub-satellite point trajectory overlaps with the sub-satellite point trajectory of the previous regression cycle:

$$D * \times 2\,\pi = N \times \Delta\,\lambda$$

wherein, N is the number of orbits of the satellite orbiting the Earth in a regression period, D* is the number of ascending days in the regression period, and $\Delta\lambda$ is the traverse angle;
the perigee orbit altitude and the apogee orbit altitude are synchronously adjusted, while ensuring the constraint of the sun-synchronous orbit, design of the orbit period, orbit precession, and the Earth's rotation speed is matched to obtain the regression orbit; and
the points on the orbital altitude relationship curve are selected based on the Q value, and the parameters of the regression orbit are calculated iteratively in the range of the mid-orbit elliptical orbit with the perigee orbit altitude of 350km~1000km, the apogee orbit altitude of 6800km~8300km, and orbit inclination of 116.565°.

6. The orbit design system for a global carbon inventory satellite according to claim 5, wherein:

the apogee of the global carbon inventory satellite is set over a specific latitude in the northern hemisphere by adjusting the argument of the perigee, so that the transit time of the global carbon inventory satellite in the northern hemisphere in the region of more intensive human activities is longer, in order to observe the northern hemisphere for a longer period of time; and

according to the proportional relationship between the argument of perigee and the latitude of apogee, the argument of perigee is determined, 35 degrees of north latitude is selected as the position of apogee, and 220 degrees is selected as the perigee argument of the global carbon inventory satellite.

7. The orbit design system for a global carbon inventory satellite according to claim 6, wherein:

the working arc segment of the global carbon inventory satellite load is at the apogee of the northern hemisphere according to the working characteristics of the global carbon inventory satellite, so that the satellite flight direction in the light area is an ascending orbit, so as to realize:

the satellite has no sunlight in the shadow area of the Earth and consumes battery power, after entering the light area, the satellite is located in the southern hemisphere, carrying out observation missions while the solar panels are recharged in preparation for long-duration observations in the northern hemisphere; and

after the satellite enters the light area, the external heat flow reaches temperature equilibrium, and the satellite reaches a stable thermal equilibrium state prior to centralized observation in the northern hemisphere in order to enhance the data quality of the infrared channel.

8. The orbit design system for a global carbon inventory satellite according to claim 1, wherein:

when the satellite is at different latitudes, the local time of the sub-satellite point changes, and the corresponding solar elevation changes accordingly;

when the local time of the descending node is 0 o'clock, the local time curves of the sub-satellite point of different latitudes are drawn, wherein the horizontal axis is latitude, the southern latitude is negative, the northern latitude is positive, from left to right is an orbit-raising process, and the vertical axis is the local time of the sub-satellite point; when the satellite is at southern latitude, the local time is afternoon; when the satellite crosses the equator, the local time is 12 noon; when observing in the northern hemisphere, the local time is morning, wherein a typical orbit near the apogee of 35° N. latitude having a local time of about 10:45 am; and

according to the actual need to translate the right ascension of the ascending node, the local time is shifted accordingly, and the adjustment method is as follows: for every 15 ° increase in the right ascension of the ascending node, the local time of the corresponding sub-satellite point is increased by one hour.

**Patentansprüche**

1. Orbitentwurfssystem für einen Global-Kohlenstoff-Inventur-Satelliten, umfassend:

eine Langverweil-Einheit in der nördlichen Hemisphäre, die konfiguriert ist, um zu ermöglichen, dass der Global-Kohlenstoff-Inventur-Satellit in einem elliptischen Orbit mit mittlerer Umlaufbahn arbeitet, und um zu ermöglichen, dass der Global-Kohlenstoff-Inventur-Satellit über dem Breitengrad der Region mit intensiver menschlicher Aktivität angeordnet ist, wenn er bis zu seinem Apogäum arbeitet, wobei der Breitengrad der Region mit intensiver menschlicher Aktivität zwischen 20°N und 45°N liegt,

eine Eingefrorener-Orbit-Einheit, die konfiguriert ist, um eine spezielle Orbitneigung einzustellen, so dass der Global-Kohlenstoff-Inventur-Satellit auch in einem eingefrorenen Orbit arbeitet, wobei das Apogäum des eingefrorenen Orbits über dem Breitengrad der Region mit intensiver menschlicher Aktivität eingefroren ist;

eine Sonnensynchroner-Orbit-Einheit, die konfiguriert ist, um Synchronisationsparameter einzustellen, so dass der Global-Kohlenstoff-Inventur-Satellit auch in einem sonnensynchronen Orbit arbeitet, so dass der Global-Kohlenstoff-Inventur-Satellit immer im hellen Bereich ist, wenn er bis zum Apogäum arbeitet; und

eine Regression-Orbit-Einheit, die konfiguriert ist, um zu ermöglichen, dass der Global-Kohlenstoff-Inventur-Satellit auch in einem Regressionsorbit arbeitet, wobei Beobachtungsbedingungen erhalten werden, die mit dem vorherigen Regressionszyklus übereinstimmen,

wobei die Beziehung zwischen der Perigäumorbithöhe und der Apogäumorbithöhe gemäß dem Wert des aufsteigenden Knotens des sonnensynchronen Orbits, dem Wert der Orbitneigung, der ersten Funktion und der zweiten Funktion erhalten wird;

wobei die erste Funktion die Beziehung zwischen der Halbhauptachse des Orbits einerseits und der Perigäumorbithöhe und der Apogäumorbithöhe andererseits darstellt; und

wobei die zweite Funktion die Beziehung zwischen der Orbitexzentrizität einerseits und der Perigäumorbithöhe und der Apogäumorbithöhe andererseits darstellt.

2. Orbitentwurfssystem für einen Global-Kohlenstoff-Inventur-Satelliten nach Anspruch 1,

wobei: die Synchronisationsparameter Orbitneigung, Orbithalblängenachse und Orbitexzentrizität umfassen; die Beobachtungsbedingungen Satellitenhöhenwinkel und Sonnenhöhenwinkel des Beobachtungspunkts umfassen; und die Orbitparameter des Global-Kohlenstoff-Inventur-Satelliten umfassen: der Bereich der Perigäumorbithöhe ist 350 km~1000 km, der Bereich der Apogäumorbithöhe ist 6800 km~8300 km, der Bereich des Perigäumarguments 215°~235° beträgt.

3. Orbitentwurfssystem für einen Global-Kohlenstoff-Inventur-Satelliten nach Anspruch 2, wobei: der elliptische Orbit mit mittlerer Umlaufbahn in einen prograden elliptischen eingefrorenen Orbit und einen retrograden elliptischen eingefrorenen Orbit gemäß der Größe der kritischen Neigung unterteilt ist, die Orbitneigung des prograden elliptischen eingefrorenen Orbits 63,4° beträgt und die Orbitneigung des retrograden elliptischen eingefrorenen Orbits 116,565° beträgt; und gemäß der Anforderung, dass sich der aufsteigende Knoten des sonnensynchronen Orbits jeden Tag um etwa 0,9856° nach Osten bewegt, die Orbitneigung des Global-Kohlenstoff-Inventur-Satelliten als 116,565° ausgewählt wird.

4. Orbitentwurfssystem für einen Global-Kohlenstoff-Inventur-Satelliten nach Anspruch 1, wobei: die Präzessionswinkelrate der Orbitebene

$$\Omega = -9{,}964 \times R\, e\, a\, 3{,}5 \times 1 - e\, 2 - 2 \times \cos^\circ /\, \mathrm{Tag}$$

ist, wobei Re der Radius der Erde ist, a die Halbhauptachse des Orbits ist, e die Orbitexzentrizität ist und i die Orbitneigung ist; der Wert des aufsteigenden Knotens des sonnensynchronen Orbits die folgenden Bedingungen erfüllt:

$$\Omega = -9{,}964 \times R\, e\, a\, 3{,}5 \times 1 - e\, 2 - 2 \times \cos = 0{,}985612288° /\, \mathrm{Tag}$$

wobei die Orbitneigung 116,565° beträgt; die erste Funktion a = (hp + ha)/2 + RE ist; die zweite Funktion

$$e = 1 - h\, p + R\, E\, h\, p + h\, a\, /\, 2 + R\, E \text{ ist;}$$

wobei hp die Perigäumorbithöhe ist, ha die Apogäumorbithöhe ist und RE der Radius der Erde ist; die Orbitneigung, die erste Funktion und die zweite Funktion ersetzt werden, um die Kombinationsgleichungen der Perigäumorbithöhe hp und der Apogäumorbithöhe ha zu erhalten; und die Orbithöhenbeziehungskurve gemäß den Kombinationsgleichungen erhalten wird.

5. Orbitentwurfssystem für einen Global-Kohlenstoff-Inventur-Satelliten nach Anspruch 4, wobei: der Regressionsorbit nach Durchlaufen eines Regressionszyklus, die Subsatellitenpunkttrajektorie mit der Subsatellitenpunkttrajektorie des vorherigen Regressionszyklus überlappt:

$$D * \times 2\, \pi = N \times \Delta\, \lambda$$

wobei N die Anzahl von Orbiten des Satelliten ist, der die Erde in einer Regressionsperiode umkreist, D* die Anzahl von aufsteigenden Tagen in der Regressionsperiode ist und $\Delta\lambda$ der Traversierwinkel ist; die Perigäumorbithöhe und die Apogäumorbithöhe synchron angepasst werden, während die Beschränkung des sonnensynchronen Orbits, Entwurf der Orbitperiode, Orbitpräzession sichergestellt werden, und die Rotationsgeschwindigkeit der Erde angepasst wird, um den Regressionsorbit zu erhalten; und die Punkte auf der Orbithöhenbeziehungskurve basierend auf dem Q-Wert ausgewählt werden, und die Parameter des Regressionsorbit iterativ im Bereich des elliptischen Orbits mit mittlerer Umlaufbahn mit der Perigäumorbithöhe von 350 km~ 1000 km, der Apogäumorbithöhe von 6800 km~8300 km und Orbitneigung von 116,565° berechnet werden.

6. Orbitentwurfssystem für einen Global-Kohlenstoff-Inventur-Satelliten nach Anspruch 5, wobei:

das Apogäum des Global-Kohlenstoff-Inventur-Satelliten über einen spezifischen Breitengrad in der nördlichen Hemisphäre durch Anpassen des Arguments des Pergäums eingestellt wird, so dass die Transitzeit des Global-Kohlenstoff-Inventur-Satelliten in der nördlichen Hemisphäre in der Region mit intensiveren menschlichen Aktivitäten länger ist, um die nördliche Hemisphäre für einen längeren Zeitraum zu beobachten; und
gemäß der proportionalen Beziehung zwischen dem Argument des Pergäums und dem Breitengrad des Apogäums das Argument des Pergäum bestimmt wird, 35 Grad des nördlichen Breitengrads als die Position des Apogäums ausgewählt wird, und 220 Grad als das Perigäumargument des Global-Kohlenstoff-Inventur-Satelliten ausgewählt wird.

7. Orbitentwurfssystem für einen Global-Kohlenstoff-Inventur-Satelliten nach Anspruch 6, wobei:
das Arbeitsbogensegment der Global-Kohlenstoff-Inventur-Satelliten-Last am Apogäum der nördlichen Hemisphäre gemäß den Arbeitseigenschaften des Global-Kohlenstoff-Inventur-Satelliten ist, so dass die Satellitenflugrichtung im hellen Bereich ein aufsteigender Orbit ist, um zu realisieren:

der Satellit hat kein Sonnenlicht im Schattenbereich der Erde und verbraucht Batterieleistung, nach dem Eintritt in den hellen Bereich befindet sich der Satellit in der südlichen Hemisphäre, wobei Beobachtungsmissionen durchgeführt werden, während die Solarpanels in Vorbereitung auf langanhaltende Beobachtungen in der nördlichen Hemisphäre aufgeladen werden; und
nachdem der Satellit in den hellen Bereich eintritt, der externe Wärmefluss Temperaturgleichgewicht erreicht, und der Satellit einen stabilen thermischen Gleichgewichtszustand vor zentralisierter Beobachtung in der nördlichen Hemisphäre erreicht, um die Datenqualität des Infrarotkanals zu verbessern.

8. Orbitentwurfssystem für einen Global-Kohlenstoff-Inventur-Satelliten nach Anspruch 1, wobei:

wenn sich der Satellit in unterschiedlichen Breitengraden befindet, die lokale Zeit des Subsatellitenpunkts sich ändert, und die entsprechende Sonnenhöhe sich dementsprechend ändert;
wenn die lokale Zeit des absteigenden Knotens 0 Uhr ist, die lokalen Zeitkurven des Subsatellitenpunkts mit unterschiedlichen Breitengraden gezeichnet werden, wobei die horizontale Achse Breitengrad ist, der südliche Breitengrad negativ ist, der nördliche Breitengrad positiv ist, von links nach rechts ein Orbiterhöhungsprozess ist und die vertikale Achse die lokale Zeit des Subsatellitenpunkts ist;
wenn sich der Satellit im südlichen Breitengrad befindet, die lokale Zeit Nachmittag ist; wenn der Satellit den Äquator überquert, die lokale Zeit 12 Mittag ist; wenn in der nördlichen Hemisphäre beobachtet wird, die lokale Zeit Morgen ist, wobei ein typischer Orbit nahe dem Apogäum von 35° N. Breitengrad eine lokale Zeit von etwa 10:45 Uhr hat; und
gemäß der tatsächlichen Notwendigkeit, den rechten Aufstieg des aufsteigenden Knotens zu übersetzen, die lokale Zeit dementsprechend verschoben wird, und das Anpassungsverfahren wie folgt ist: für jede 15°-Zunahme des rechten Aufstiegs des aufsteigenden Knotens wird die lokale Zeit des entsprechenden Subsatellitenpunkts um eine Stunde erhöht.

**Revendications**

1. Système de conception d'orbite pour un satellite mondial d'inventaire de carbone, comprenant :

une unité de longue résidence dans l'hémisphère nord, configurée pour permettre au satellite mondial d'inventaire de carbone de fonctionner sur une orbite elliptique à mi-orbite, et permettre au satellite mondial d'inventaire de carbone d'être situé au-dessus de la latitude de la région intensive d'activité humaine lorsqu'il fonctionne jusqu'à son apogée, dans lequel la latitude de la région intensive d'activité humaine est comprise entre 20°N et 45°N,
une unité d'orbite gelée, configurée pour régler une inclinaison orbitale spéciale de sorte que le satellite mondial d'inventaire de carbone fonctionne également sur une orbite gelée, l'apogée de l'orbite gelée étant gelée sur la latitude de la région intensive d'activité humaine ;
une unité d'orbite héliosynchrone, configurée pour régler des paramètres de synchronisation de sorte que le satellite mondial d'inventaire de carbone fonctionne également sur une orbite héliosynchrone, de sorte que le satellite mondial d'inventaire de carbone est toujours dans la zone de lumière lorsqu'il fonctionne jusqu'à l'apogée ; et

une unité d'orbite de régression, configurée pour permettre au satellite mondial d'inventaire de carbone de fonctionner également sur une orbite de régression, obtenant des conditions d'observation cohérentes avec le cycle de régression précédent,

dans lequel la relation entre l'altitude orbitale de périgée et l'altitude orbitale d'apogée est obtenue selon la valeur du nœud ascendant de l'orbite héliosynchrone, la valeur de l'inclinaison orbitale, la première fonction et la seconde fonction ;

dans lequel la première fonction représente la relation entre le demi-grand axe de l'orbite d'une part et l'altitude orbitale de périgée et l'altitude orbitale d'apogée d'autre part ; et

dans lequel la seconde fonction représente la relation entre l'excentricité orbitale d'une part et l'altitude orbitale de périgée et l'altitude orbitale d'apogée d'autre part.

2. Système de conception d'orbite pour un satellite mondial d'inventaire de carbone selon la revendication 1,

dans lequel : les paramètres de synchronisation comprennent une inclinaison orbitale, un axe de demi-longueur d'orbite et une excentricité d'orbite ;

les conditions d'observation comprennent un angle d'élévation de satellite et un angle d'altitude solaire du point d'observation ; et

les paramètres orbitaux du satellite mondial d'inventaire de carbone comprennent :
la plage d'altitude orbitale de périgée est de 350 km ~ 1000 km, la plage d'altitude orbitale d'apogée est de 6800 km ~ 8300 km, la plage d'altitude de périgée est de 215° ~ 235°.

3. Système de conception d'orbite pour un satellite mondial d'inventaire de carbone selon la revendication 2, dans lequel : l'orbite elliptique à mi-orbite est divisée en une orbite gelée elliptique prograde et une orbite gelée elliptique rétrograde selon la taille de l'inclinaison critique, l'inclinaison orbitale de l'orbite gelée elliptique prograde est de 63,4°, et l'inclinaison orbitale de l'orbite gelée elliptique rétrograde est de 116,565° ; et

selon l'exigence selon laquelle le nœud ascendant de l'orbite héliosynchrone se déplace vers l'est d'environ 0,9856° chaque jour, l'inclinaison orbitale du satellite mondial d'inventaire de carbone est sélectionnée comme étant de 116,565°.

4. Système de conception d'orbite pour un satellite mondial d'inventaire de carbone selon la revendication 1, dans lequel : la vitesse angulaire de précession du plan orbital est

$$\Omega = -9{,}964 \times R\,e\,a\,3{,}5 \times 1 - e\,2 - 2 \times \cos° / jour$$

dans lequel, Re est le rayon de la Terre, a est le demi-grand axe de l'orbite, e est l'excentricité orbitale, et i est l'inclinaison orbitale ;

la valeur du nœud ascendant de l'orbite héliosynchrone satisfait les conditions suivantes :

$$\Omega = -9{,}964 \times R\,e\,a\,3{,}5 \times 1 - e\,2 - 2 \times \cos = 0{,}985612288° / jour$$

dans lequel, l'inclinaison orbitale est de 116,565° ;
la première fonction est a = (hp + ha)/2 + RE ;
la seconde fonction est

$$e = 1 - h\,p + R\,E\,h\,p + h\,a / 2 + R\,E ;$$

dans lequel, hp est l'altitude d'orbite de périgée, ha est l'altitude d'orbite d'apogée, et RE est le rayon de la Terre ;
l'inclinaison orbitale, la première fonction et la seconde fonction sont substituées pour obtenir les équations de combinaison de l'altitude orbitale de périgée hp et de l'altitude orbitale d'apogée ha ; et
la courbe de relation d'altitude orbitale est obtenue selon les équations de combinaison.

5. Système de conception d'orbite pour un satellite mondial d'inventaire de carbone selon la revendication 4, dans lequel : l'orbite de régression après avoir traversé un cycle de régression, la trajectoire de point de sous-satellite chevauche la trajectoire de point de sous-satellite du cycle de régression précédent :

$$D * \times 2\,\pi = N \times \Delta\lambda$$

dans lequel, N est le nombre d'orbites du satellite orbitant autour de la Terre dans une période de régression, D* est le nombre de jours ascendants dans la période de régression, et Δλ est l'angle transversal ; l'altitude d'orbite de périgée et l'altitude d'orbite d'apogée sont ajustées de manière synchrone, tout en assurant la contrainte de l'orbite héliosynchrone, la conception de la période d'orbite, la précession d'orbite, et la vitesse de rotation de la Terre est adaptée pour obtenir l'orbite de régression ; et les points sur la courbe de relation d'altitude orbitale sont sélectionnés sur la base de la valeur Q, et les paramètres de l'orbite de régression sont calculés de manière itérative dans la plage de l'orbite elliptique à mi-orbite avec l'altitude d'orbite de périgée de 350 km ~ 1000 km, l'altitude d'orbite d'apogée de 6800 km ~ 8300 km, et une inclinaison d'orbite de 116,565°.

6. Système de conception d'orbite pour un satellite mondial d'inventaire de carbone selon la revendication 5, dans lequel :

l'apogée du satellite mondial d'inventaire de carbone est réglée sur une latitude spécifique dans l'hémisphère nord en ajustant l'altitude de la périgée, de sorte que le temps de transit du satellite mondial d'inventaire de carbone dans l'hémisphère nord dans la région d'activités humaines plus intensives est plus long, afin d'observer l'hémisphère nord pendant une période de temps plus longue ; et selon la relation proportionnelle entre l'altitude de périgée et la latitude d'apogée, l'altitude de périgée est déterminée, 35 degrés de latitude nord sont sélectionnés en tant que position d'apogée, et 220 degrés sont sélectionnés en tant qu'altitude de périgée du satellite mondial d'inventaire de carbone.

7. Système de conception d'orbite pour un satellite mondial d'inventaire de carbone selon la revendication 6, dans lequel :
le segment d'arc de travail de la charge du satellite mondial d'inventaire de carbone est à l'apogée de l'hémisphère nord selon les caractéristiques de travail du satellite mondial d'inventaire de carbone, de sorte que la direction de vol du satellite dans la zone de lumière est une orbite ascendante, afin de réaliser :

le satellite n'a pas de lumière solaire dans la zone d'ombre de la Terre et consomme de l'énergie de batterie, après être entré dans la zone de lumière, le satellite est situé dans l'hémisphère sud, effectuant des missions d'observation alors que les panneaux solaires sont rechargés en préparation pour des observations de longue durée dans l'hémisphère nord ; et après que le satellite est entré dans la zone de lumière, le flux de chaleur externe atteint un équilibre de température, et le satellite atteint un état d'équilibre thermique stable avant une observation centralisée dans l'hémisphère nord afin d'améliorer la qualité des données du canal infrarouge.

8. Système de conception d'orbite pour un satellite mondial d'inventaire de carbone selon la revendication 1, dans lequel :

lorsque le satellite est à des latitudes différentes, le temps local du point de sous-satellite change, et l'élévation solaire correspondante change en conséquence ; lorsque le temps local du nœud descendant est de 0 heure, les courbes de temps local du point de sous-satellite de latitudes différentes sont tracées, dans lequel l'axe horizontal est latitude, la latitude sud est négative, la latitude nord est positive, de gauche à droite est un processus d'élévation d'orbite, et l'axe vertical est le temps local du point de sous-satellite ; lorsque le satellite est à latitude sud, le temps local est l'après-midi ; lorsque le satellite traverse l'équateur, le temps local est de 12 heures ; lorsqu'il est observé dans l'hémisphère nord, le temps local est le matin, dans lequel une orbite typique proche de l'apogée de latitude de 35° N. a un temps local d'environ 10 h 45 ; et selon le besoin réel de traduire l'ascension à droite du nœud ascendant, le temps local est décalé en conséquence, et le procédé d'ajustement est comme suit : pour chaque augmentation de 15° dans l'ascension à droite du nœud ascendant, le temps local du point de sous-satellite correspondant est augmenté d'une heure.

**Figure 1**

**Figure 2**

Figure 3

argument of perigee (deg)

Figure 4

**Figure 5**

**EP 4 365 767 B1**

**Patent documents cited in the description**

- US 6102335 A